# EUROPEAN PATENT APPLICATION

(11) **EP 4 339 321 A1**
(43) Date of publication of application: **20.03.2024**
(21) Application number: 23195219.3
(22) Date of filing: 04.09.2023
(51) Int. Cl.: C23C 14/04, C23C 14/50, H01L 21/68

(54) **STAGE UNIT, DEPOSITION APPARATUS INCLUDING THE SAME, AND DISPLAY PANEL MANUFACTURING METHOD**

(30) Priority: 08.09.2022 KR 20220114037
(71) Applicant: Samsung Display Co., Ltd., Gyeonggi-Do (KR)
(72) Inventor: Kyongho, HONG, Yongin-si (KR); PARK, Sungho, Yongin-si (KR); LEE, Jungseob, Yongin-si (KR); KO, Junhyeuk, Yongin-si (KR); KIM, Euigyu, Yongin-si (KR); YI, Sang Min, Yongin-si (KR); HAN, Sangjin, Yongin-si (KR)
(74) Representative: Marks & Clerk LLP

(57) **Abstract**

A stage unit includes a stage that provides a seating surface and has an opening formed through the seating surface, a first support unit disposed below the opening and coupled to the stage, a second support unit disposed below the opening and coupled to the stage, where the second support unit is spaced apart from the first support unit on a plane, and a flatness measurement unit supported by the first support unit. Each of the first support unit and the second support unit provides a support surface that crosses the seating surface, and the support surface of the first support unit and the support surface of the second support unit are movable in a direction toward and away from the opening.

## Description

### BACKGROUND

### 1. Field

Embodiments of the disclosure described herein relate to a stage unit, a deposition apparatus including the same, and a display panel manufacturing method, and more particularly, to a stage unit for vertical deposition, a deposition apparatus including the same, and a display panel manufacturing method.

### 2. Description of the Related Art

Display devices, such as a television, a mobile phone, a tablet computer, a car navigation unit, a game machine, and the like, may include a display panel for displaying an image. The display panel may include a plurality of pixels. Each of the pixels may include a drive element such as a transistor and a display element such as an organic light emitting diode. The display element may be formed by depositing electrodes and a light emitting pattern on a substrate.

The light emitting pattern may be formed on a predetermined region by using a mask having a deposition opening defined therein. Recently, in order to improve the production yields of display panels, a deposition process technology using a large area mask has been developed. However, in a case in which the mask is not aligned at a designed position in a deposition apparatus, the accuracy of a position in which a light emitting pattern is formed may be deteriorated.

### SUMMARY

Embodiments of the disclosure provide a stage unit for providing a flattened support surface to an object and a deposition apparatus including the stage unit.

In addition, embodiments of the disclosure provide a display panel manufacturing method having improved deposition accuracy.

According to an embodiment, a stage unit includes a stage that provides a seating surface and has an opening formed through the seating surface, a first support unit disposed below the opening and coupled to the stage, a second support unit disposed below the opening and coupled to the stage, the second support unit being spaced apart from the first support unit on a plane, and a flatness measurement unit supported by the first support unit. Each of the first support unit and the second support unit provides a support surface which crosses the seating surface, and the support surface of the first support unit and the support surface of the second support unit are movable in a direction toward and away from the opening.

In an embodiment, the seating surface may be substantially parallel to a direction of gravity.

In an embodiment, the support surface of the first support unit and the support surface of the second support unit may be movable in a direction substantially parallel to a direction of gravity.

An embodiment of the first support unit may include a first support bar that provides a first support surface among the support surfaces, a second support bar that provides a second support surface among the support surfaces and which is spaced apart from the first support bar in a first direction, and a link bar that connects the first support bar and the second support bar, wherein the flatness measurement unit may contact the link bar.

An embodiment of the stage unit may further include a first hinge connected through the first support bar and one side of the link bar and a second hinge connected through the second support bar and an opposite side of the link bar. In an embodiment, when the support surface of the first support unit and the support surface of the second support unit move, a position of the first hinge may be fixed, and a position of the second hinge may be changed.

In an embodiment, the first support surface and the second support surface may define the same plane or different planes.

In an embodiment, the second support unit may include a plurality of blocks disposed between the first support bar and the second support bar, where each of the blocks may provide a third support surface that defines the support surface.

In an embodiment, the blocks may be independently movable in a second direction crossing the first direction, and the third support surfaces may define the same plane or different planes.

In an embodiment, the stage unit may further include an additional flatness measurement unit that controls flatness of the third support surfaces and the first and second support surfaces.

In an embodiment, the stage unit may further include a wireless communication module connected with the first support unit and the second support unit.

According to an embodiment, a deposition apparatus may include a chamber that provides an inner space, a deposition member that is accommodated in the inner space and which provides a deposition material, a stage that provides a seating surface parallel to a plane defined by a first direction and a second direction and which has an opening formed through a portion of the seating surface, a mask unit which is disposed on the seating surface to overlap the opening and which has a plurality of openings defined therein, a lower support unit that is disposed below the opening and coupled to the stage and which supports the mask unit, and a substrate including a front surface that faces the seating surface, the substrate being spaced apart from the deposition member in a third direction crossing the first direction and the second direction with the mask unit and the stage therebetween. The lower support unit may include a support unit that provides a support surface in contact with one side surface of the mask unit that extends in the first direction and a flatness measurement unit disposed on the support unit, where the support surface is connected with the flatness measurement unit and movable in the second direction.

In an embodiment, the inner space may be in a vacuum state.

In an embodiment, the mask unit may include a mask frame having an opening that overlaps the opening of the stage and a plurality of masks, each of which has the plurality of openings defined therein, the plurality of masks being disposed to overlap the opening of the mask frame.

An embodiment of the deposition apparatus may further include a communication module connected to the lower support unit, where the communication module may be capable of communication with the outside of the chamber.

In an embodiment, the support surface may include a first support surface that supports one end of the one side surface of the mask unit, a second support surface that supports an opposite end of the one side surface of the mask unit, and a plurality of third support surfaces disposed between the first support surface and the second support surface and arranged in the first direction to be spaced apart from each other, where the first support surface, second support surface and/or third support surface may be independently controlled.

In an embodiment, the flatness measurement unit may measure (e.g. may be configured to measure) flatness between the first support surface and the second support surface.

According to an embodiment, a method for manufacturing a display panel includes providing a stage unit including a stage that provides a seating surface and a lower support unit that provides a support surface, setting a reference position at which the support surface is flattened, providing an object on the seating surface, and aligning the lower support unit such that a support surface which supports the object corresponds to the reference position. The support surface crosses the seating surface, and a flatness measurement unit is used to set the reference position.

In an embodiment, the support surface may cross a direction of gravity.

In an embodiment, the support surface may include a plurality of support surfaces, where positions of the support surfaces may be independently movable in a direction of gravity when the lower support unit is aligned.

In an embodiment, the setting of the reference position may be performed in an atmospheric pressure state.

In an embodiment, the aligning of the lower support unit may be performed in a vacuum state.

At least some of the above and other features of the invention are set out in the claims.

### BRIEF DESCRIPTION OF THE FIGURES

The above and other features of embodiments of the disclosure will become apparent by describing in detail embodiments thereof with reference to the accompanying drawings.
FIG. 1 is a sectional view of a display panel according to an embodiment of the disclosure.
FIG. 2 is a sectional view of a deposition apparatus according to an embodiment of the disclosure.
FIG. 3 is an exploded perspective view of the deposition apparatus according to an embodiment of the disclosure.
FIG. 4A is a plan view illustrating an operation of a lower support unit according to an embodiment of the disclosure.
FIG. 4B is a plan view illustrating an operation of a lower support unit according to an embodiment of the disclosure.
FIG. 4C is a plan view illustrating an operation of a lower support unit according to an embodiment of the disclosure.
FIG. 5A is a plan view illustrating an operation of the lower support unit according to an embodiment of the disclosure.
FIG. 5B is a plan view illustrating an operation of the lower support unit according to an embodiment of the disclosure.
FIG. 6 is a flowchart illustrating a manufacturing process according to an embodiment of the disclosure.
FIG. 7A is a plan view illustrating the manufacturing process according to an embodiment of the disclosure.
FIG. 7B is a plan view illustrating the manufacturing process according to an embodiment of the disclosure.
FIG. 7C is a plan view illustrating the manufacturing process according to an embodiment of the disclosure.
FIG. 7D is a plan view illustrating the manufacturing process according to an embodiment of the disclosure.
FIG. 7E is a plan view illustrating the manufacturing process according to an embodiment of the disclosure.
FIG. 7F is a plan view illustrating the manufacturing process according to an embodiment of the disclosure.
FIG. 8A is a plan view illustrating the manufacturing process according to an embodiment of the disclosure.
FIG. 8B is a plan view illustrating the manufacturing process according to an embodiment of the disclosure.
FIG. 9 is a flowchart illustrating a manufacturing process according to an embodiment of the disclosure.
FIG. 10A is a plan view illustrating the manufacturing process according to an embodiment of the disclosure.
FIG. 10B is a plan view illustrating the manufacturing process according to an embodiment of the disclosure.
FIG. 11 is a flowchart illustrating a display panel manufacturing process according to an embodiment of the disclosure.
FIG. 12A is a plan view illustrating the display panel manufacturing process according to an embodiment of the disclosure.
FIG. 12B is a plan view illustrating the display panel manufacturing process according to an embodiment of the disclosure.
FIG. 13A is a plan view illustrating the display panel manufacturing process according to an embodiment of the disclosure.
FIG. 13B is a plan view illustrating the display panel manufacturing process according to an embodiment of the disclosure.
FIG. 14 is a flowchart illustrating a display panel manufacturing method according to an embodiment of the disclosure.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

In this specification, when it is mentioned that a component (or, a region, a layer, a part, etc.) is referred to as being "on", "connected to" or "coupled to" another component, this means that the component may be directly on, connected to, or coupled to the other component or a third component may be present therebetween.

Identical reference numerals refer to identical components. Additionally, in the drawings, the thicknesses, proportions, and dimensions of components may be exaggerated for effective description.

As used herein, the term "and/or" includes all of one or more combinations defined by related components.

Terms such as first, second, and the like may be used to describe various components, but the components should not be limited by the terms. The terms may be used for distinguishing one component from other components. For example, without departing the scope of the disclosure, a first component may be referred to as a second component, and similarly, the second component may also be referred to as the first component. The terms of a singular form may include plural forms unless otherwise specified.

In addition, terms such as "below", "under", "above", and "over" may be used to describe a relationship of components illustrated in the drawings. The terms may be relative concepts and may be described based on directions illustrated in the drawings.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms used herein, including technical or scientific terms, have the same meanings as those generally understood by those skilled in the art to which the disclosure pertains. Such terms as those defined in a generally used dictionary should be interpreted as having meanings equal to the contextual meanings in the relevant field of art, and should not be interpreted as having ideal or excessively formal meanings unless clearly defined as having such in the present application.

It should be understood that terms such as "comprise", "include", and "have", when used herein, may specify the presence of stated features, numbers, steps, operations, components, parts, or combinations thereof, but do not preclude the presence and/or addition of one or more other features, numbers, steps, operations, components, parts, or combinations thereof.

Hereinafter, embodiments of the disclosure will be described with reference to the accompanying drawings.

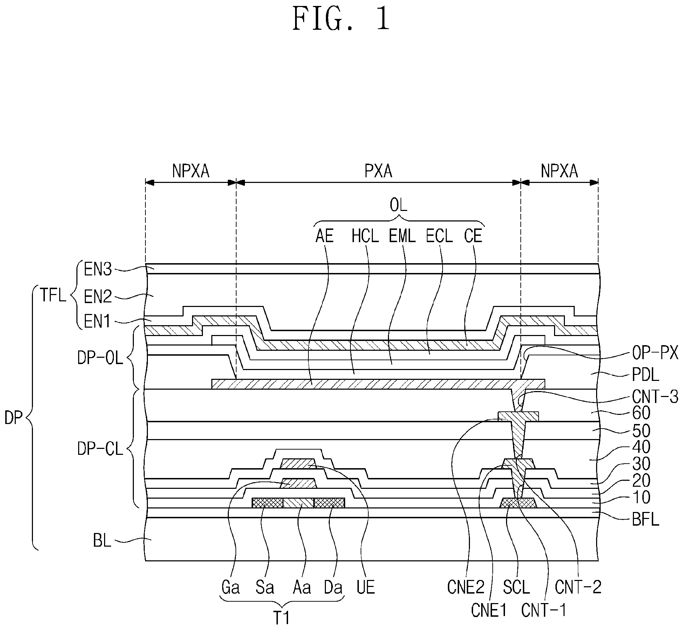

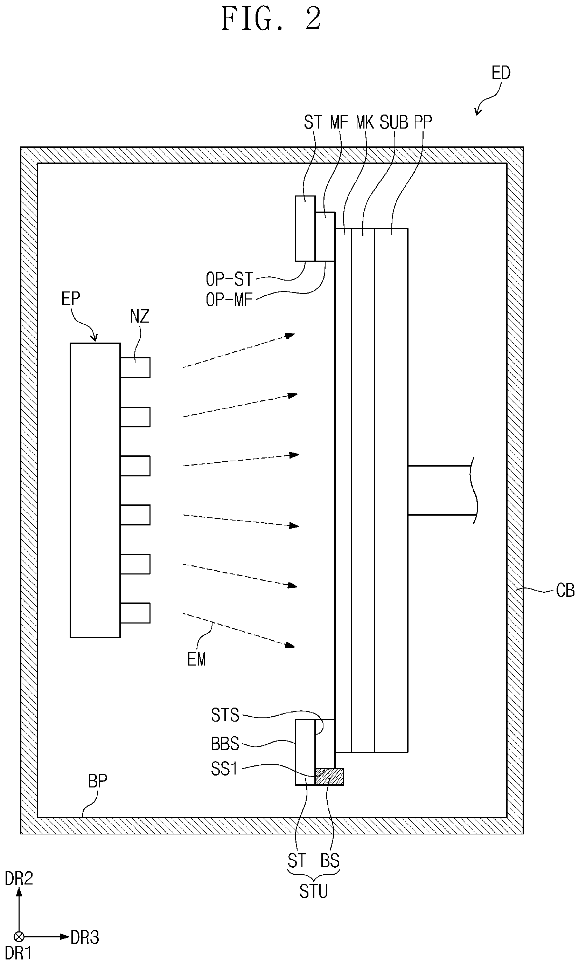

FIG. 1 is a sectional view of a display panel according to an embodiment of the disclosure. A deposition apparatus ED (refer to FIG. 2) according to an embodiment of the disclosure, which will be described below, may be used to form at least a part of functional layers included in the display panel DP. FIG. 1 illustrates a section of the display panel DP manufactured by using the deposition apparatus ED (refer to FIG. 2).

In an embodiment, the display panel DP may be an emissive display panel. In an embodiment, for example, the display panel DP may be an organic light emitting display panel, an inorganic light emitting display panel, and/or a quantum-dot light emitting display panel. An emissive layer of the organic light emitting display panel may include an organic light emitting material, and/or an emissive layer of the inorganic light emitting display panel may include an inorganic light emitting material. An emissive layer of the quantum-dot light emitting display panel may include quantum dots and/or quantum rods. Hereinafter, it will be exemplified that the display panel DP is an organic light emitting display panel, but should be limited thereto.

In an embodiment, the display panel DP may include a plurality of pixels. Each of the pixels may include at least one transistor T1 and a light emitting element OL. FIG. 1 illustrates a region in which the transistor T1 and the light emitting element OL of one of the pixels of the display panel DP are disposed. Referring to FIG. 1, the display panel DP may include a base layer BL, a circuit element layer DP-CL, a display element layer DP-OL, and an encapsulation layer TFL.

In an embodiment, the base layer BL may provide a base surface on which the circuit element layer DP-CL is disposed. The base layer BL may include a synthetic resin layer. A synthetic resin layer may be formed on a support substrate that is used in the manufacture of the display panel DP, and a conductive layer and an insulating layer may be formed on the synthetic resin layer. Thereafter, in an embodiment, the support substrate may be removed, and the synthetic resin layer from which the support plate is removed may correspond to the base layer BL.

In an embodiment, an inorganic layer may be disposed on an upper surface of the base layer BL. The inorganic layer may constitute a barrier layer and/or a buffer layer. FIG. 1 illustrates a buffer layer BFL disposed on the base layer BL. The buffer layer BFL may improve a coupling force between the base layer BL and a semiconductor pattern of the circuit element layer DP-CL.

In an embodiment, a circuit element layer DP-CL may be disposed on the buffer layer BFL. The circuit element layer DP-CL may include an insulating layer and a circuit element. The circuit element may include a signal line and a pixel drive circuit. The circuit element layer DP-CL may be formed through a process of forming an insulating layer, a semiconductor layer, and/or a conductive layer by coating, deposition, or the like and/or a process of making the insulating layer, the semiconductor layer, and/or the conductive layer subject to patterning by a photolithography process.

In an embodiment, the circuit element layer DP-CL may include the transistor T1, a connecting signal line SCL, connecting electrodes CNE1 and CNE2, and a plurality of insulating layers 10 to 60. The plurality of insulating layers 10 to 60 may include the first to sixth insulating layers 10 to 60, respectively, sequentially stacked on the buffer layer BFL. Each of the first to sixth insulating layers 10 to 60, respectively, may include one of an inorganic layer and/or an organic layer.

In an embodiment, the transistor T1 may include a semiconductor pattern including a source region Sa, an active region Aa, a drain region Da, and a gate electrode Ga. The semiconductor pattern of the transistor T1 may include poly silicon. However, without being limited thereto, the semiconductor pattern may include amorphous silicon and/or metal oxide.

In an embodiment, the semiconductor pattern may be divided into a plurality of regions depending on conductivities. In an embodiment, for example, the semiconductor pattern may have different electrical properties depending on whether doping is performed or whether metal oxide is reduced. A high-conductivity region in the semiconductor pattern may serve as an electrode and/or a signal line and may correspond to the source region Sa and the drain region Da of the transistor T1. A non-doped or non-reduced region having relatively low conductivity may correspond to the active region Aa (or, the channel region) of the transistor T1.

In an embodiment, the connecting signal line SCL may be formed from the semiconductor pattern and may be disposed on the same layer as the source region Sa, the active region Aa, and/or the drain region Da of the transistor T1. According to an embodiment, the connecting signal line SCL may be electrically connected to the drain region Da of the transistor T1 on the plane.

In an embodiment, the first insulating layer 10 may cover the semiconductor pattern of the circuit element layer DP-CL. The gate electrode Ga may be disposed on the first insulating layer 10. The gate electrode Ga may overlap the active region Aa on the plane. The gate electrode Ga may function as a mask in a process of doping the semiconductor pattern. An upper electrode UE may be disposed on the second insulating layer 20. The upper electrode UE may overlap the gate electrode Ga on the plane.

In an embodiment, the first connecting electrode CNE1 and the second connecting electrode CNE2 may be disposed between the transistor T1 and the light emitting element OL and may electrically connect the transistor T1 and the light emitting element OL. The first connecting electrode CNE1 may be disposed on the third insulating layer 30 and may be connected to the connecting signal line SCL through a contact hole CNT-1 penetrating the first to third insulating layers 10 to 30, respectively. The second connecting electrode CNE2 may be disposed on the fifth insulating layer 50 and may be connected to the first connecting electrode CNE1 through a contact hole CNT-2 penetrating the fourth and fifth insulating layers 40 and 50, respectively.

In an embodiment, the display element layer DP-OL may be disposed on the circuit element layer DP-CL. The display element layer DP-OL may include the light emitting element OL and a pixel defining film PDL. The light emitting element ED may include a first electrode AE, a second electrode CE, and an intermediate layer disposed between the first electrode AE and the second electrode CE. The intermediate layer may include an organic layer, and in this embodiment, the intermediate layer is illustrated as including a hole control layer HCL, an emissive layer EML, and an electron control layer ECL. However, this is illustrative, and the intermediate layer may further include an additional layer, in addition to the hole control layer HCL, the emissive layer EML, and the electron control layer ECL. Alternatively, at least one of the hole control layer HCL, the emissive layer EML, and the electron control layer ECL may be omitted, and the disclosure is not limited to any one embodiment.

In an embodiment, the first electrode AE and the pixel defining film PDL may be disposed on the sixth insulating layer 60. The first electrode AE may be connected to the second connecting electrode CNE2 through a contact hole CNT-3 penetrating the sixth insulating layer 60. The pixel defining film PDL may have a light emitting opening OP-PX defined therein through which at least a portion of the first electrode AE may be exposed, and the portion of the first electrode AE exposed through the light emitting opening OP-PX may correspond to an emissive region PXA. A non-emissive region NPXA may surround the emissive region PXA.

In an embodiment, the hole control layer HCL and the electron control layer ECL may be commonly disposed in the emissive region PXA and/or the non-emissive region NPXA. The emissive layer EML may be formed in a pattern form to correspond to the light emitting opening OP-PX. The emissive layer EML in a pattern form may be formed by using the deposition apparatus ED (refer to FIG. 2) according to an embodiment of the disclosure.

In an embodiment, compared to the hole control layer HCL and the electron control layer ECL that have a film form, the emissive layer EML may be deposited in a different way. In an embodiment, for example, the hole control layer HCL and the electron control layer ECL may be commonly formed for the pixels by using a mask referred to as an open mask. The emissive layer EML may be differently formed depending on the pixels by using a mask referred to as a fine metal mask (FMM).

In an embodiment, the encapsulation layer TFL may include a thin film. The encapsulation layer TFL of one embodiment may include first to third thin films EN1, EN2, and EN3, respectively, that are sequentially stacked one above another. Each of the first to third thin films EN1, EN2, and EN3, respectively, may include an inorganic film and/or an organic film. The inorganic film may protect the light emitting element OL from moisture and/or oxygen. The organic film may protect the light emitting element OL from foreign matter such as dust particles. However, in an embodiment, a configuration of the encapsulation layer TFL may not be limited to that illustrated in the drawing if the encapsulation layer TFL is capable of protecting the light emitting element OL or improving light emission efficiency.

FIG. 2 is a sectional view of the deposition apparatus according to an embodiment of the disclosure. Referring to FIG. 2, an embodiment of the deposition apparatus ED may include a chamber CB, a deposition member EP, a fixing member PP, a mask MK, a mask frame MF, a stage ST, and a lower support unit BS. In an embodiment, the deposition apparatus ED may further include an additional mechanical apparatus for implementing an in-line system.

In an embodiment, the chamber CB provides an inner space, and the deposition member EP, the fixing member PP, the mask MK, the mask frame MF, and a stage unit STU may be disposed in the inner space of the chamber CB. In an embodiment, the chamber CB may provide a sealed space and may set a deposition condition to vacuum. The chamber CB may include a gate and the chamber CB may be opened and closed through the gate. The stage unit STU, the mask MK, the mask frame MF, and a substrate SUB may enter and exit the chamber CB through the gate.

In an embodiment, the chamber CB may include a bottom wall BP, a top wall, and sidewalls. The bottom wall BP of the chamber CB may be parallel to a plane defined by a first direction DR1 and a third direction DR3, and the normal direction of the bottom wall BP of the chamber CB may be parallel to a second direction DR2. In this specification, "on a plane" is set based on a plane parallel to a plane defined by the first direction DR1 and the second direction DR2.

In an embodiment, the fixing member PP may be disposed in the chamber CB and may fix the substrate SUB to the mask MK. The fixing member PP may include a jig or a robot arm that holds the mask MK. The fixing member PP may include magnetic bodies for bringing the substrate SUB into close contact with the mask MK. In an embodiment, for example, the magnetic bodies may generate a magnetic force to fix the mask MK and may bring the substrate SUB between the mask MK and the fixing member PP into close contact with the mask MK.

In an embodiment, the substrate SUB may be an object on which a deposition material EM is deposited. The substrate SUB may include a support substrate and/or a synthetic resin layer disposed on the support substrate. The support substrate may be removed in a later stage of a manufacturing process of the display panel, and the synthetic resin layer may correspond to the base layer BL of FIG. 1. Depending on a configuration formed through a deposition process, an embodiment of the substrate SUB may include the base layer BL (refer to FIG. 1) and some components of the display panel DP (refer to FIG. 1) formed on the base layer BL (refer to FIG. 1).

In an embodiment, the deposition member EP may be disposed in the chamber CB to face the fixing member PP. The deposition member EP may include a space in which the deposition material EM is accommodated and may include a nozzle NZ. The deposition material EM may include an inorganic material, metal, and/or an organic material which is capable of sublimation or vaporization. In an embodiment, for example, the deposition material EM may include an organic light emitting material for forming the emissive layer EML (refer to FIG. 1). However, the deposition material EM is not limited to the above example. The sublimated or vaporized deposition material EM may be jetted toward the substrate SUB through the nozzle NZ. The deposition material EM may be deposited in a predetermined pattern on the substrate SUB through the mask MK.

In an embodiment, the stage unit STU may include the stage ST and the lower support unit BS. The stage ST may be disposed between the deposition member EP and the fixing member PP. The stage ST may support a rear surface of the mask frame MF and may be disposed outward of a movement path of the deposition material EM supplied from the deposition member EP toward the substrate SUB.

In an embodiment, the stage ST may include a seating surface STS on which the mask frame MF is seated and a rear surface BBS facing away from the seating surface STS. The seating surface STS of the stage ST may be inclined with respect to the bottom wall BP of the chamber CB. In an embodiment, for example, the seating surface STS of the stage ST may be in a direction substantially perpendicular to the direction of the surface of the bottom wall BP of the chamber CB. Accordingly, a deposition process may be performed in a state in which rear surfaces of the mask frame MF and the mask MK that are disposed on the seating surface STS of the stage ST may be in a direction substantially perpendicular to the direction of the surface of the bottom wall BP of the chamber CB. Thus, the mask MK having a large area may be prevented from sagging due to the gravity, and deposition reliability may be improved.

However, the disclosure is not limited thereto, and according to an embodiment, the seating surface STS of the stage ST may be inclined slightly (e.g., at an angle of about 70 degrees or more) with respect to the bottom wall BP of the chamber CB. According to the disclosure, an embodiment of the seating surface STS of the stage ST may not be parallel to the bottom wall BP of the chamber CB. Accordingly, in an embodiment, the mask MK may be prevented from sagging due to the gravity, and the bottom wall BP of the chamber CB may be designed to have an area smaller than or equal to the area of the substrate SUB. Thus, the area occupied by the chamber CB may be decreased.

In an embodiment, the mask MK may include deposition openings that define deposition regions. The mask frame MF may be coupled to the mask MK and may support the mask MK. The mask frame MF may include an upper surface facing the mask MK, the rear surface facing away from the upper surface and facing the seating surface STS of the stage ST, and side surfaces connecting the upper surface and the rear surface. An embodiment of the mask frame MF may include a plurality of portions that define an opening OP-MF overlapping the deposition openings of the mask MK. That is, the mask frame MF may have a frame shape surrounding the opening OP-MF on the plane. Detailed description thereabout will be given below.

In an embodiment, the lower support unit BS may be connected to the stage ST and may support the mask frame MF. The lower support unit BS may face a side surface SS1 of the mask frame MF in the second direction DR2 and may support the side surface SS1 of the mask frame MF. In this embodiment, the side surface SS1 of the mask frame MF supported by the lower support unit BS may face the bottom wall BP of the chamber CB. In this embodiment, the bottom wall BP and the side surface SS1 of the mask frame MF may be parallel to each other. However, this is illustrative, and in an embodiment, the bottom wall BP and the side surface SS1 of the mask frame MF may have a predetermined inclination. An embodiment of the mask frame MF may be disposed at an angle at which the side surface SS1 of the mask frame MF is supported by a supporting force applied in a direction parallel to the direction of gravity. That is, the lower support unit BS may support the mask frame MF which may be substantially vertically seated in the chamber CB. In an embodiment, the lower support unit BS may move in a direction parallel to the second direction DR2, and thus a force applied to the mask frame MF may be adjusted by the lower support unit BS. Detailed description thereabout will be given below.

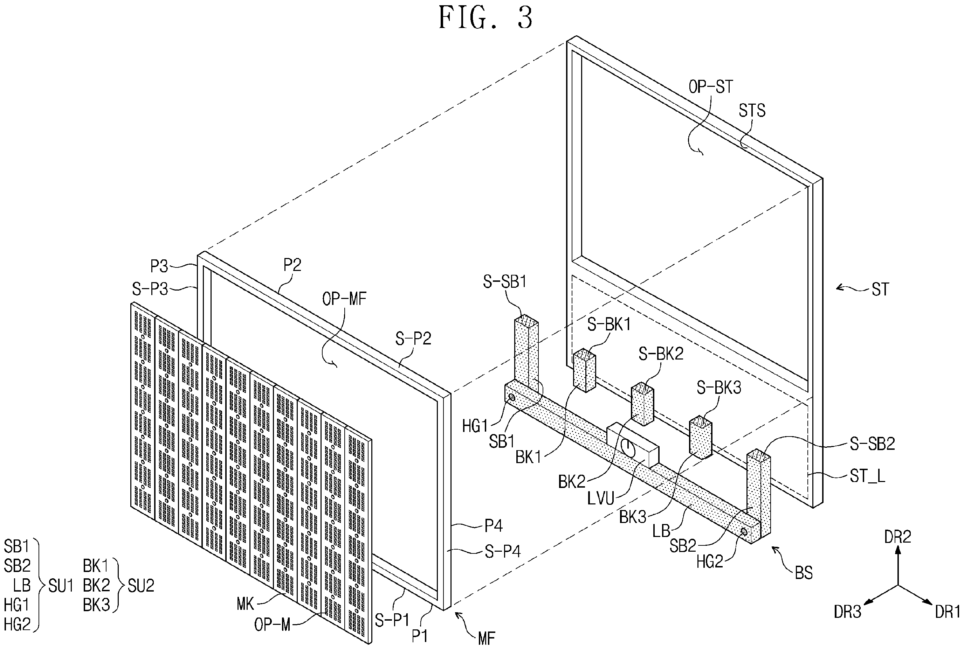

FIG. 3 is an exploded perspective view of the deposition apparatus according to an embodiment of the disclosure. Referring to FIG. 3, an embodiment of the mask frame MF may have a rectangular closed line shape on the plane. The mask frame MF may include a plurality of portions P1, P2, P3, and P4 that define the opening OP-MF. The plurality of portions P1, P2, P3, and P4 may surround the opening OP-MF and may be integrally formed. The plurality of portions P1, P2, P3, and P4 may provide the single mask frame MF. The first portion P1 and the second portion P2 may extend in the first direction DR1, and the third portion P3 and the fourth portion P4 may extend in the second direction DR2.

In an embodiment, the plurality of portions P1, P2, P3, and P4 may include side surfaces S-P1, S-P2, S-P3, and S-P4 that define an outer surface of the mask frame MF. The side surface SS1 of the mask frame MF described above with reference to FIG. 2 may be one of the side surfaces S-P1, S-P2, S-P3, and S-P4 of the plurality of portions P1, P2, P3, and P4. In this embodiment, the side surface SS1 is illustrated as corresponding to the side surface S-P1 of the first portion P1. However, embodiments are not necessarily limited thereto.

In an embodiment, the mask frame MF may have a predetermined stiffness. For example, the mask frame MF may include a metallic material such as stainless steel (SUS), an Invar alloy, nickel (Ni), cobalt (Co), and/or the like.

In an embodiment, the mask frame MF may provide a support surface on which the mask MK is disposed. The support surface on which the mask MK is disposed may correspond to the upper surface of the mask frame MF, and/or the surface facing away from the upper surface and facing the seating surface STS of the stage ST may correspond to the rear surface of the mask frame MF.

In an embodiment, a plurality of masks MK may be provided. The masks MK may be disposed on one mask frame MF. The masks MK may be fixedly coupled to the mask frame MF. In an embodiment, for example, the masks MK may overlap the opening OP-MF of the mask frame MF and may be coupled in a state of being arranged in the first direction DR1.

In an embodiment, the masks MK may extend in the second direction DR2. That is, each of the masks MK may have short sides extending in the first direction DR1 and long sides extending in the second direction DR2. However, extension directions of the masks MK are not necessarily limited thereto.

In an embodiment, each of the masks MK may be a thin plate that is thinner than the mask frame MF. The mask MK may include a metallic material such as stainless steel (SUS), an Invar alloy, nickel (Ni), cobalt (Co), and/or the like. However, the material of the mask MK is not limited to the above examples.

In an embodiment, deposition openings OP-MK may be defined in each of the masks MK. The deposition openings OP-MK may be formed through the mask MK in the thickness direction of the mask MK (e.g., the third direction DR3).

In an embodiment, the deposition openings OP-MK may be spaced apart from each other and may have a predetermined arrangement. The deposition openings OP-MK may have a rectangular shape on the plane. Without being limited thereto, the deposition openings OP-MK may have various shapes such as a rhombic shape, a circular shape, and/or the like. The number, shape, and arrangement of deposition openings OP-MK illustrated in FIG. 3 are illustrative and may vary depending on a deposition pattern to be formed.

In an embodiment, the deposition material EM (refer to FIG. 2) passing through the deposition openings OP-MK may be deposited on the substrate SUB (refer to FIG. 2) and may form deposition patterns corresponding to the shape and arrangement of the deposition openings OP-MK. In an embodiment, the deposition patterns may correspond to the emissive layer EML (refer to FIG. 1) of the display panel DP (refer to FIG. 1). However, an embodiment of the deposition patterns is not limited to any one layer as long as it is formed through deposition in the display panel DP (refer to FIG. 1).

An embodiment of the stage ST may include the seating surface STS on which the mask frame MF is seated and the rear surface BBS facing away from the seating surface STS. The seating surface STS of the stage ST may support the rear surface of the mask frame MF. The stage ST may have a shape corresponding to the shape of the mask frame MF. In an embodiment, for example, the stage ST may have a frame shape in which a stage opening OP-ST overlapping the opening OP-MF of the mask frame MF is defined. In this embodiment, the stage ST is illustrated as having a rectangular ring shape including long sides extending in the first direction DR1 and short sides extending in the second direction DR2. However, the stage ST is not limited to any one shape as long as the stage ST is capable of supporting the rear surface of the mask frame MF.

In an embodiment, the lower support unit BS may be disposed on a lower region ST_L of the stage ST. The lower region ST_L may be a region defined below the opening OP-ST. The lower support unit BS may include a first support unit SU1, a second support unit SU2, and a flatness measurement unit LVU.

In an embodiment, the first support unit SU1 may support portions of the first side surface SS1 that are adjacent to opposite ends. The first support unit SU1 may include a first support bar SB1, a second support bar SB2, and a link bar LB. The first support bar SB1 may have a bar shape extending in the second direction DR2. The first support bar SB1 may provide a support surface S-SB 1 (hereinafter, referred to as the first support surface) on an upper side. The first support surface S-SB1 may be in a direction parallel to the first direction DR1 and may be in a direction perpendicular to the second direction DR2 and/or may intersect the second direction DR2. In an embodiment, the first support surface S-SB1 makes contact with an object to be processed, for example, one end of the first side surface SS1 of the mask frame MF and supports the mask frame MF. The first support surface S-SB 1 may support the first side surface SS1 by applying an external force to the first side surface SS1 in the second direction DR2.

In an embodiment, the second support bar SB2 may be spaced apart from the first support bar SB1 in the first direction DR1. The second support bar SB2 may have a bar shape extending in the second direction DR2. The second support bar SB2 may provide a support surface S-SB2 (hereinafter, referred to as the second support surface) on an upper side. The second support surface S-SB2 may be in a direction parallel to the first direction DR1 and may be in a direction perpendicular to the second direction DR2 and/or may intersect the second direction DR2. In an embodiment, the second support surface S-SB2 makes contact with the object to be processed, for example, an opposite end of the first side surface SS1 of the mask frame MF and supports the mask frame MF. The second support surface S-SB2 may support the first side surface SS1 by applying an external force to the first side surface SS1 in the second direction DR2.

In an embodiment, the link bar LB may have a bar shape extending in the first direction DR1. The link bar LB connects the first support bar SB1 and the second support bar SB2. Specifically, one end of the link bar LB may be connected, through a first hinge HG1, with a side of the first support bar SB1 that faces away from the first support surface S-SB1, and an opposite end of the link bar LB may be connected, through a second hinge HG2, with a side of the second support bar SB2 that faces away from the second support surface S-SB2.

In an embodiment, the first hinge HG1 may pass through the first support bar SB1 and the link bar LB and may physically connect the first support bar SB1 and the link bar LB. The first support bar SB1 and the link bar LB may be coupled so as to be rotatable about the first hinge HG1. The second hinge HG2 may pass through the second support bar SB2 and the link bar LB and may physically connect the second support bar SB2 and the link bar LB. The second support bar SB2 and the link bar LB may be coupled so as to be rotatable about the second hinge HG2. Detailed description thereabout will be given below.

In an embodiment, the flatness measurement unit LVU may be disposed on the link bar LB. The flatness measurement unit LVU may be supported by the link bar LB. The flatness measurement unit LVU may substantially measures the flatness of the link bar LB. The flatness measurement unit LVU may measure whether a contact surface with the link bar LB is a horizontal surface, that is, whether the contact surface with the link bar LB is a surface in a direction perpendicular to the direction of gravity. In an embodiment, an inclination angle measured by the flatness measurement unit LVU may correspond to an inclination angle with respect to the bottom wall BP (refer to FIG. 2) of the chamber CB (refer to FIG. 2).

In this embodiment, the flatness measurement unit LVU may include an electronic level. Specifically, the flatness measurement unit LVU may be an electronic level including a gyro sensor and the like. However, this is illustrative, and the flatness measurement unit LVU may be a mechanical level including a balance weight and the like and is not limited to any one embodiment.

In an embodiment, the second support unit SU2 may include a plurality of blocks BK1, BK2, and BK3. The blocks BK1, BK2, and BK3 may include the first to third blocks BK1, BK2, and BK3, respectively. However, the number of blocks BK1, BK2, and BK3 illustrated in FIG. 3 is illustrative, and more or fewer blocks may be included in the deposition apparatus ED.

In an embodiment, the first to third blocks BK1, BK2, and BK3, respectively, may be connected to the stage ST. The first to third blocks BK1, BK2, and BK3, respectively, may be located below the opening of the stage ST on the seating surface STS of the stage ST and may be disposed adjacent to one side of the stage ST that is parallel to the first direction DR1. The first to third blocks BK1, BK2, and BK3, respectively, may be spaced apart from each other in the first direction DR1.

In an embodiment, the first to third blocks BK1, BK2, and BK3, respectively, may include support surfaces S-BK1, S-BK2, and S-BK3, respectively, (hereinafter, referred to as the third support surfaces) that face the side surface SS1 of the mask frame MF seated on the stage ST and support the side surface SS1. According to an embodiment of the disclosure, the third support surfaces S-BK1, S-BK2, and S-BK3, respectively, may face the first side surface SS1 of the mask frame MF in the second direction DR2. That is, the first to third blocks BK1, BK2, and BK3, respectively, may support the first side surface SS1 by applying an external force to the first side surface SS1 in the second direction DR2.

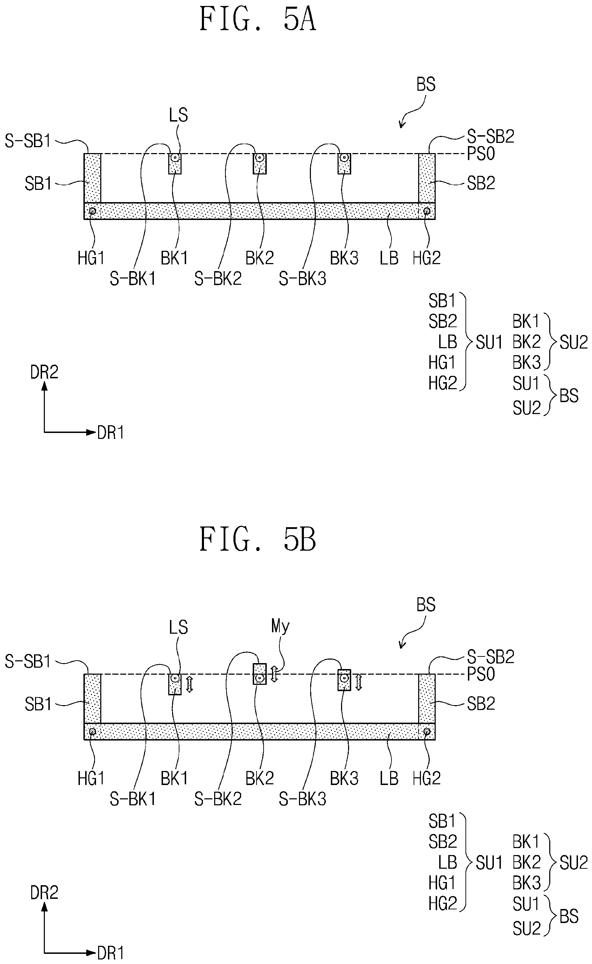

In an embodiment, the first to third blocks BK1, BK2, and BK3, respectively, may move in a direction parallel to the direction facing the side surface SS1 of the mask frame MF supported by the first to third blocks BK1, BK2, and BK3, respectively. That is, in this embodiment, the first to third blocks BK1, BK2, and BK3, respectively, may move in a direction parallel to the second direction DR2. Hereinafter, in this embodiment, the movement direction of the first to third blocks BK1, BK2, and BK3, respectively, may be defined as an up/down direction My (refer to Fig. 5B) corresponding to the second direction DR2. As the first to third blocks BK1, BK2, and BK3, respectively, move in the up/down direction My, the positions of the third support surfaces S-BK1, S-BK2, and S-BK3, respectively, may move.

In an embodiment, movements of the first to third blocks BK1, BK2, and BK3, respectively, may be independently controlled. As the first to third blocks BK1, BK2, and BK3, respectively, independently move, the positions of some of the first to third blocks BK1, BK2, and BK3, respectively, in the second direction DR2 may differ from each other. That is, the positions of the third support surfaces S-BK1, S-BK2, and S-BK3 may differ from one another. Accordingly, depending on the movements of the first to third blocks BK1, BK2, and BK3, respectively, the third support surfaces S-BK1, S-BK2, and S-BK3 may be aligned to define the same plane and/or may define different planes. In an embodiment, external forces applied to the side surface SS1 of the mask frame MF by the first to third blocks BK1, BK2, and BK3, respectively, may be controlled by controlling the positions of the first to third blocks BK1, BK2, and BK3, respectively. The position of the mask frame MF seated on the stage ST may be aligned by moving the first to third blocks BK1, BK2, and BK3, respectively, and thus the accuracy of the positions at which deposition patterns are formed may be improved.

Furthermore, an embodiment of the lower support unit BS according to the disclosure, which further includes the second support unit SU2, may maintain flatness with high accuracy even for a large area mask unit extending in the first direction DR1. By providing an external force through the second support unit SU2 to regions that are difficult to be supported by only the first support unit SU1, an even supporting force may be provided to the entire region of the large area mask unit. Accordingly, the object may be stably processed. Meanwhile, although FIG. 3 briefly illustrates the shapes of the plurality of blocks BK1, BK2, and BK3, the plurality of blocks BK1, BK2, and BK3 are not limited to any one shape as long as the positions of the blocks BK1, BK2, and BK3 are able to be adjusted while the blocks BK1, BK2, and BK3 support the side surface SS1 of the mask frame MF.

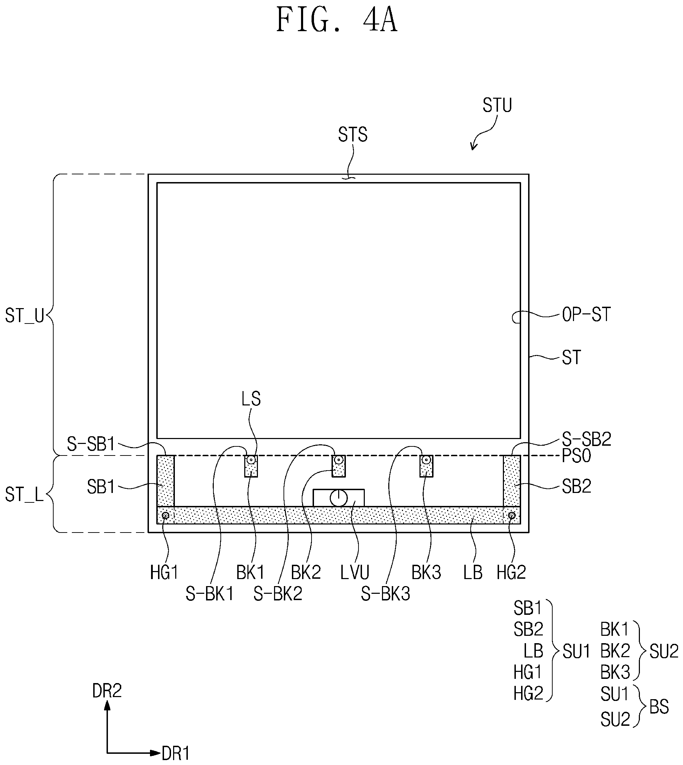

FIGS. 4A to 4C are plan views illustrating an operation of the lower support unit according to an embodiment of the disclosure. FIGS. 5A and 5B are plan views illustrating an operation of the lower support unit according to an embodiment of the disclosure. FIGS. 4A to 4C illustrate an operation of the first support unit, and FIGS. 5A and 5B illustrate an operation of the second support unit. FIGS. 4A to 5B are plan views illustrating the front side of the stage unit STU. Hereinafter, the lower support unit BS will be described with reference to FIGS. 4A to 5B. Meanwhile, components identical to the components described with reference to FIGS. 1 to 3 will be assigned with identical reference numerals, and repetitive descriptions will be omitted.

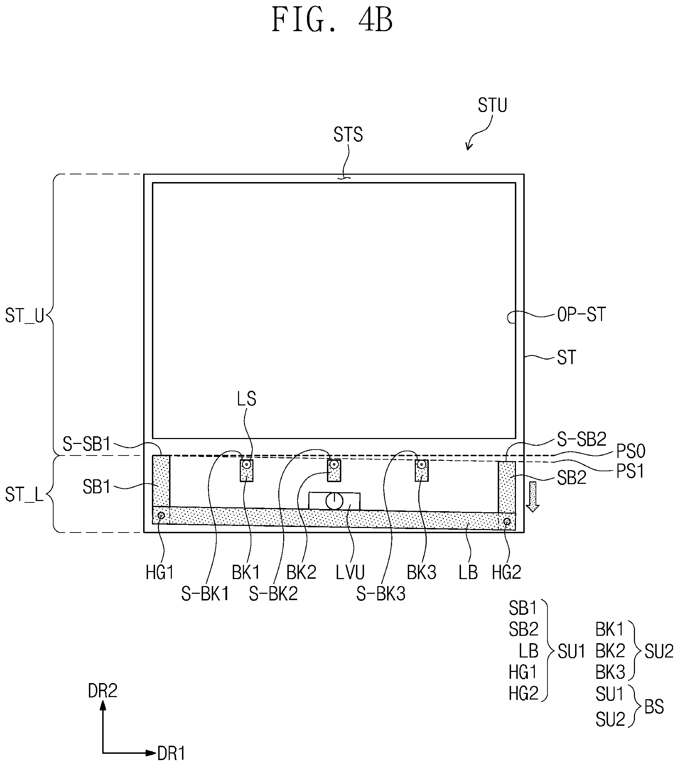

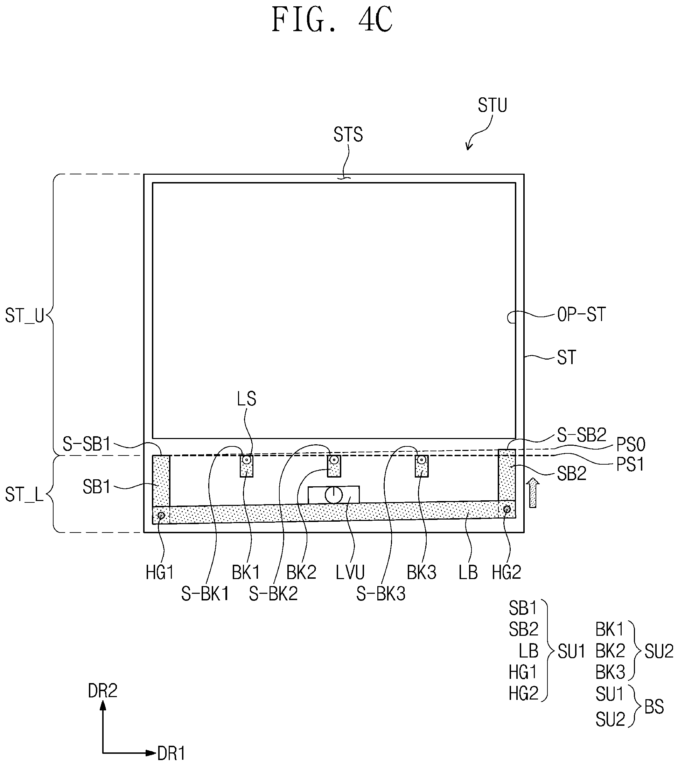

As illustrated in FIGS. 4A to 4C, an embodiment of the first support unit SU1 may control the positions of the support surfaces S-SB1 and S-SB2 by moving the position of the second support bar SB2. FIGS. 4B and 4C illustrate states in which the support surfaces S-SB1 and S-SB2 define different planes, and FIG. 4A illustrates a state in which the support surfaces S-SB1 and S-SB2 may be aligned along a virtual reference position PSO.

In an embodiment, when the link bar LB is inclined downward to the right on the plane as illustrated in FIG. 4B, the second support surface S-SB2 may be located farther away from the opening OP-ST than the first support surface S-SB 1. The inclined state of the link bar LB may be substantially measured by the flatness measurement unit LVU. The flatness measurement unit LVU may measure the degree to which the link bar LB is inclined and may transfer data corresponding to a measurement value to a driving part (not illustrated) of the lower support unit BS. In an embodiment, the driving part may be provided in various forms as long as the driving part is capable of controlling movement of the lower support unit BS by providing a physical force through a gear or a motor. The driving part adjusts the slope of the link bar LB, based on the measurement value measured by the flatness measurement unit LVU. Accordingly, the second support surface S-SB2 may move in the direction of an arrow. That is, the second support surface S-SB2 may move in a direction parallel to the second direction DR2 to move away from the opening OP-ST.

In an embodiment, the flatness measurement unit LVU may measure the flatness of the link bar LB in real time, and the link bar LB may continue to move until the measurement value measured by the flatness measurement unit LVU corresponds to a result value that the inclination of the link bar LB is equal to 0 (zero). Accordingly, as illustrated in FIG. 4A, an alignment step of the first support unit SU1 may continue until the second support surface S-SB2 and the first support surface S-SB1 are aligned along the reference position PSO to define the same plane.

Alternatively, in an embodiment, when the link bar LB is inclined upward to the right on the plane as illustrated in FIG. 4C, the second support surface S-SB2 may be located closer to the opening OP-ST than the first support surface S-SB1. The driving part of the lower support unit BS may adjust the slope of the link bar LB, based on a measurement value measured by the flatness measurement unit LVU. Accordingly, the second support surface S-SB2 may move in the direction of an arrow. That is, the second support surface S-SB2 may move toward the opening OP-ST in a direction parallel to the second direction DR2.

In an embodiment, the link bar LB may continue to move until the measurement value measured by the flatness measurement unit LVU corresponds to a result value that the inclination of the link bar LB is equal to 0 (zero). Accordingly, as illustrated in FIG. 4A, an alignment step of the first support unit SU1 may continue until the second support surface S-SB2 and the first support surface S-SB 1 are aligned along the reference position PSO to define the same plane.

In an embodiment and as illustrated in FIGS. 5A and 5B, an alignment step of the lower support unit BS may include an alignment step of the second support unit SU2. FIG. 5A illustrates a state in which the third support surfaces S-BK1, S-BK2, and S-BK3 provided by the second support unit SU2 are aligned along the reference position PS0, and FIG. 5B illustrates a state in which the third support surfaces S-BK1, S-BK2, and S-BK3 define different planes.

In an embodiment, as illustrated in FIG. 5A, a plane defined by the third support surfaces S-BK1, S-BK2, and S-BK3 may be one plane and may be a plane that coincides with the reference position PSO. In this embodiment, the third support surfaces S-BK1, S-BK2, and S-BK3 may be aligned with the first and second support surfaces S-SB1 and S-SB2 and may provide substantially the same plane as the first and second support surfaces S-SB1 and S-SB2.

In an embodiment, an object according to the disclosure is in an upright position in a direction parallel to the direction of gravity. That is, the seating surface may be parallel to the direction of gravity or slightly inclined. As the lower support unit supports a side surface rather than a front or rear surface of the object, the support surface provided by the lower support unit may cross the seating surface and may face the side surface of the object. As the side surface defining the thickness has a smaller area than the front surface, supporting the side surface may be significantly affected by the load of the object, compared to supporting the front surface of the object.

In an embodiment as the object seated on the stage ST is supported by the plurality of support surfaces S-SB1, S-SB2, S-BK1, S-BK2, and S-BK3 with respect to a side extending in the first direction DR1, an even supporting force may be provided in the first direction DR1 even though a load is concentrated on a portion of the side extending along the first direction DR1. Accordingly, the object may be stably supported even though a length extending in the first direction DR1 is increased.

In an embodiment, as illustrated in FIG. 5B, planes defined by the third support surfaces S-BK1, S-BK2, and S-BK3 may be different planes and may not be aligned with the reference position PS0. In this embodiment, the blocks BK1, BK2, and BK3 may be independently driven. Each of the blocks BK1, BK2, and BK3 may include a displacement sensor LS. Each of the blocks BK1, BK2, and BK3 may obtain information about each position and a position (displacement) moved relative to the reference position through the displacement sensor. Driving parts that drive the blocks BK1, BK2, and BK3 may move the blocks BK1, BK2, and BK3 in the second direction DR2 in response to displacement data measured through the displacement sensors.

In an embodiment, for example, when the blocks BK1, BK2, and BK3 are moved relative to the reference position PSO as illustrated in FIG. 5B, based on displacement data stored in the displacement sensors LS of the blocks BK1, BK2, and BK3, the position of the first block BK1 may be maintained, the position of the second block BK2 may be moved in a direction away from the opening OP-ST, and the position of the third block BK3 may be moved in a direction toward the opening OP-ST. Accordingly, the support surfaces S-BK1, S-BK2, and S-BK3 may be aligned with the reference position PS0. Meanwhile, this is illustrative, and if the blocks BK1, BK2, and BK3 are capable of providing a supporting force to the object in the state in which the object is aligned, the positions of the blocks BK1, BK2, and BK3 may differ from the reference position PSO and are not limited to any one embodiment.

In an embodiment, according to the disclosure, the second support unit SU2 is further included, and thus an additional supporting force may be provided to the object between the first and second support surfaces S-SB1 and S-SB2. Accordingly, a problem that the first support unit SU1 is deformed as a concentrated load is generated on the first and second support surfaces S-SB1 and S-SB2 may be prevented, and a load may be evenly distributed to the third support surfaces S-BK1, S-BK2, and S-BK3. In addition, in an embodiment, movements of the blocks BK1, BK2, and BK3 may be independently controlled, and thus the positions of the third support surfaces S-BK1, S-BK2, and S-BK3 may be independently controlled. Accordingly, a more stable and detailed alignment step may be achieved.

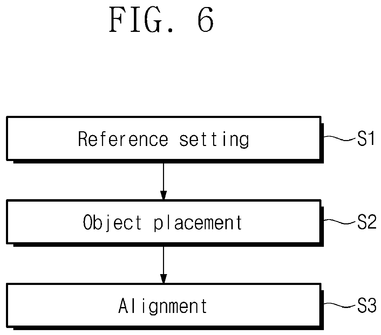

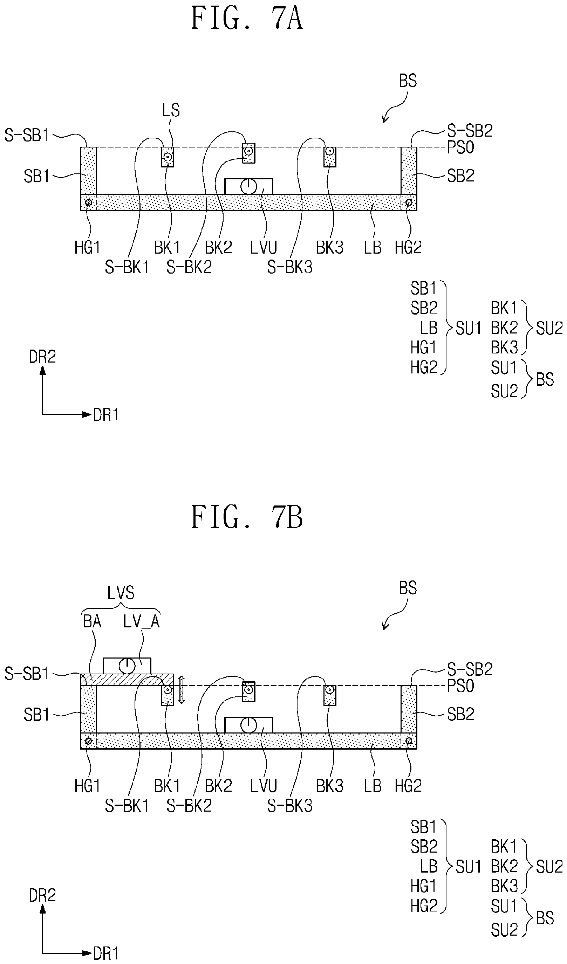

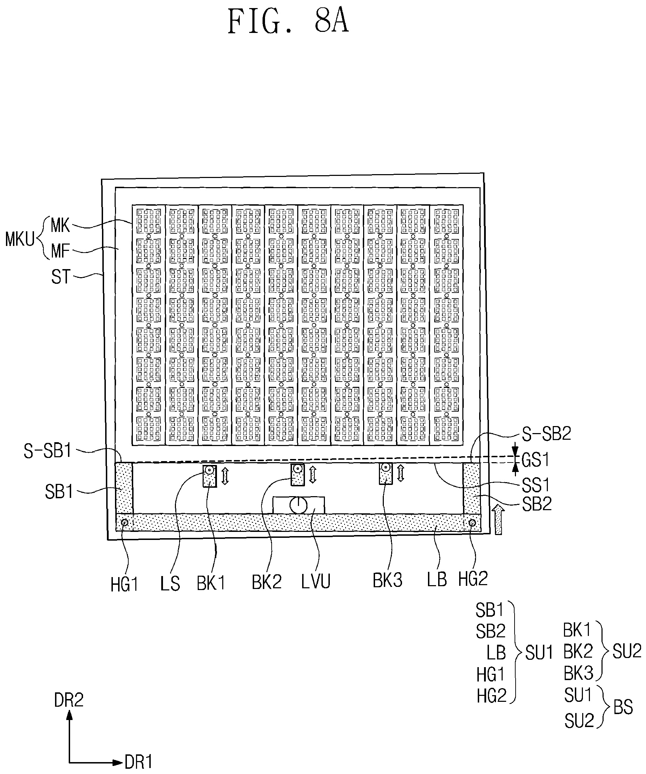

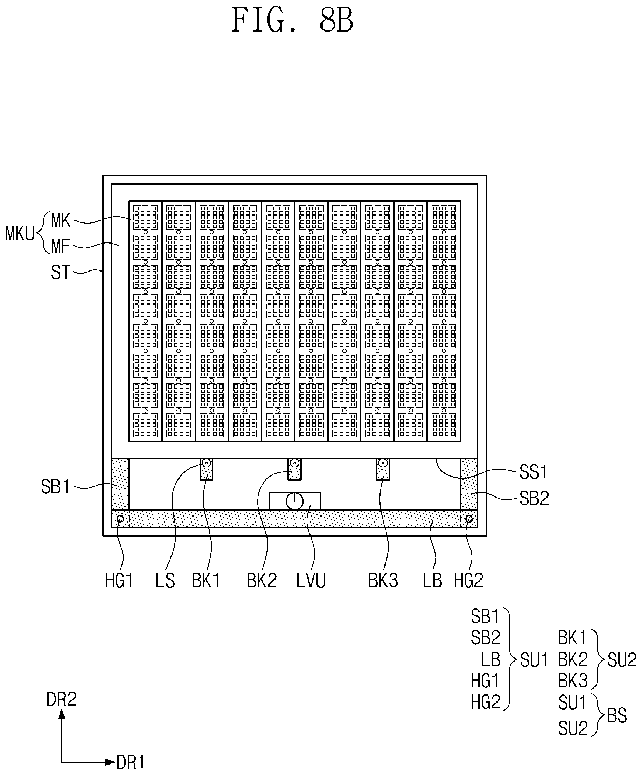

FIG. 6 is a flowchart illustrating a manufacturing process according to an embodiment of the disclosure. FIGS. 7A to 7E are plan views illustrating the manufacturing process according to an embodiment of the disclosure. FIGS. 8A and 8B are plan views illustrating the manufacturing process according to an embodiment of the disclosure. Hereinafter, the disclosure will be described with reference to FIGS. 6 to 8B. Meanwhile, components identical to the components described with reference to FIGS. 1 to 5B will be assigned with identical reference numerals, and repetitive descriptions may be omitted.

As illustrated in FIG. 6, the manufacturing process according to an embodiment of the disclosure may include a reference setting step S1, an object placement step S2, and an alignment step S3. In an embodiment, the reference setting step S1 may be a step of setting the reference position PSO (refer to FIG. 4A) in the stage unit STU (refer to FIG. 2) before an object is disposed. In an embodiment, the reference setting step S1 may be a step of setting horizontality before the object is seated on the stage ST (refer to FIG. 2), and/or the support surfaces S-SB1, S-SB2, S-BK1, S-BK2, and S-BK3 of the lower support unit BS (refer to FIG. 2) may be set to be flat in a state in which the load of the object does not exist.

In an embodiment, the object placement step S2 may be a step in which the object is seated on the stage ST. Depending on the horizontality of the object, the load of the object may be applied to at least one of the support surfaces S-SB1, S-SB2, S-BK1, S-BK2, and S-BK3 provided by the lower support unit BS. In an embodiment, when the object is seated in a flat state, the load applied to the support surfaces S-SB1, S-SB2, S-BK1, S-BK2, and S-BK3 may be evenly distributed. However, in an embodiment, a concentrated load may be applied to a part of the support surfaces S-SB1, S-SB2, S-BK1, S-BK2, and S-BK3 as the flatness of the object is not good, and therefore the flatness of the lower support unit BS may be different from the state set in the reference setting step S1.

Meanwhile, in an embodiment, the object may be diversely selected as long as it is an object to be seated on the stage ST. In an embodiment, for example, the object may be the mask frame MF or the mask unit MKU. Alternatively, in an embodiment, the object may be the substrate SUB. As long as the object is able to be provided on the stage ST and supported by the lower support unit BS, the object may include various embodiments and is not limited to any one embodiment.

Thereafter, in an embodiment, the lower support unit BS may be rearranged in the alignment step S3. In an embodiment, the lower support unit BS may reset the flatness of the lower support unit BS by moving the positions of the support surfaces S-SB1, S-SB2, S-BK1, S-BK2, and S-BK3. In this case, the alignment step S3 may be an alignment step before a deposition step. However, without being limited thereto, in an embodiment, the alignment step S3 may be a step of aligning the mask frame MF and the mask MK in a step of assembling the mask frame MF (refer to FIG. 2) and the mask MK (refer to FIG. 2). The alignment step S3 according to an embodiment of the disclosure may be performed on various objects if the objects are aligned with the reference position with respect to the direction of gravity and is not limited to any one embodiment.

In an embodiment, FIGS. 7A to 7E sequentially illustrate the reference setting step S1. For ease of description, only the lower support unit BS is illustrated in FIGS. 7A to 7E. Hereinafter, the reference setting step S1 will be described in more detail with reference to FIGS. 7A to 7E.

Referring to FIG. 7A, in an embodiment, the first support unit SU1 is set to a flat state using the flatness measurement unit LVU. In this case, the flatness measurement unit LVU may indicate that the link bar LB is in a flat state, that is, in a state of being in a direction parallel to the first direction DR1, and the first support surface S-SB1 and the second support surface S-SB2 may be in a state of defining the same plane as the reference position PS0.

Referring to FIGS. 7B to 7D, in an embodiment, the second support unit SU2 may be set to a flat state using an additional flatness measurement unit LVS. The additional flatness measurement unit LVS may include a level LV_A and a horizontal bar BA.

In an embodiment, the horizontal bar BA may have a bar shape extending in the first direction DR1. The horizontal bar BA may be supported by at least two support surfaces. Accordingly, the horizontal bar BA may have a length greater than or equal to the separation distance between the support surfaces. The length of the horizontal bar BA may be defined in the first direction DR1.

In an embodiment, the level LV_A may be disposed on the horizontal bar BA and may be brought into contact with the horizontal bar BA. The level LV_A may substantially measure the horizontality or flatness of the horizontal bar BA. In an embodiment, the level LV-A may include an electronic level. Specifically, the level LV-A may be an electronic level including a gyro sensor and the like. However, this is illustrative, and, in an embodiment, the level LV_A may be a mechanical level including a balance weight and the like, and is not limited to any one embodiment.

In an embodiment, the additional flatness measurement unit LVS may be disposed on two adjacent support surfaces. The additional flatness measurement unit LVS may measure horizontality or flatness between two support surfaces and may make contact with the horizontal bar BA. Specifically, referring to FIG. 7B, in an embodiment, the additional flatness measurement unit LVS measures flatness between the first support bar SB1 and the first block BK1. The horizontal bar BA is supported by the first support surface S-SB1 and the support surface S-BK1 of the first block BK1, and the level LV-A may measure the horizontality of the horizontal bar BA. As the first block BK1 is moved in the second direction DR2 based on measured data, the first support surface S-SB1 and the support surface S-BK1 of the first block BK1 may be aligned with each other.

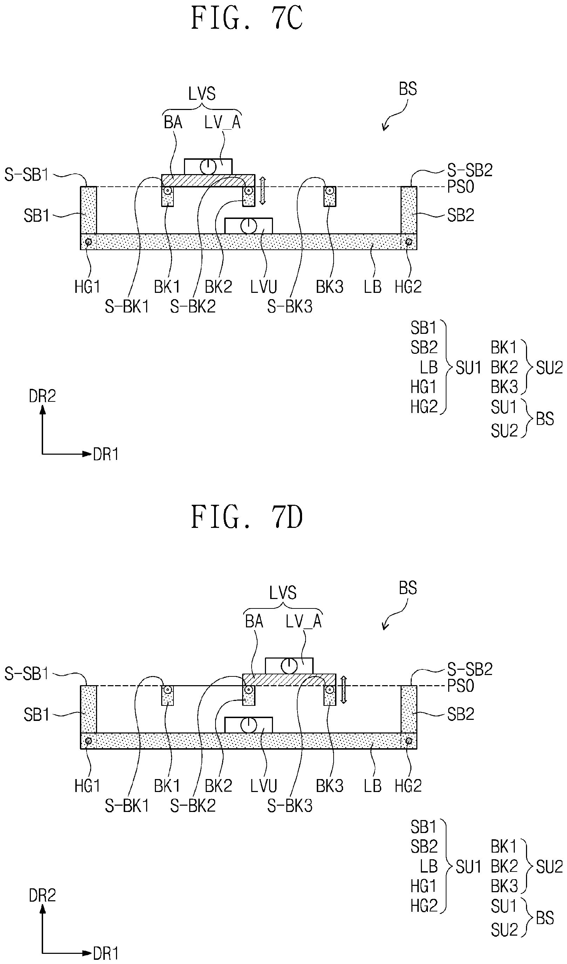

Referring to FIG. 7C, in an embodiment, the additional flatness measurement unit LVS may measure flatness between the first block BK1 and the second block BK2. The horizontal bar BA is supported by the support surface S-BK1 of the first block BK1 and the support surface S-BK2 of the second block BK2, and the level LV-A may measure the horizontality of the horizontal bar BA. As the second block BK2 is moved in the second direction DR2 based on measured data, the support surface S-BK1 of the first block BK1 and the support surface S-BK2 of the second block BK2 may be aligned with each other.

Referring to FIG. 7D, in an embodiment, the additional flatness measurement unit LVS measures flatness between the second block BK2 and the third block BK3. The horizontal bar BA is supported by the support surface S-BK2 of the second block BK2 and the support surface S-BK3 of the third block BK3, and the level LV-A may measure the horizontality of the horizontal bar BA. As the third block BK3 is moved in the second direction DR2 based on measured data, the support surface S-BK2 of the second block BK2 and the support surface S-BK3 of the third block BK3 may be aligned with each other.

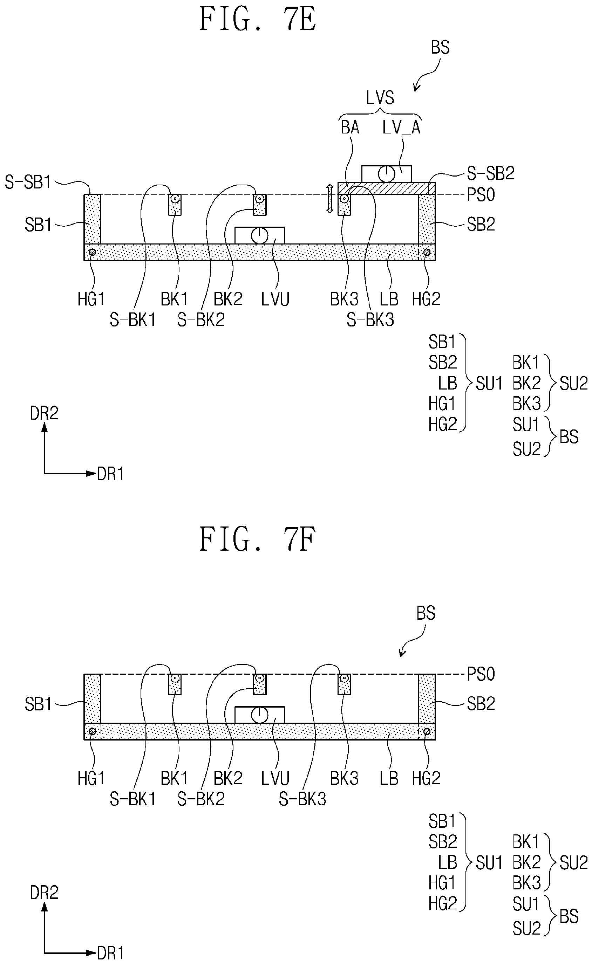

Referring to FIG. 7E, in an embodiment, the additional flatness measurement unit LVS may measure flatness between the third block BK3 and the second support bar SB2. The horizontal bar BA may be supported by the support surface S-BK3 of the third block BK3 and the second support surface S-SB2, and the level LV-A may measure the horizontality of the horizontal bar BA. As the third block BK3 or the second support bar SB2 is moved in the second direction DR2 based on measured data, the second support surface S-SB2 and the support surface S-BK3 of the third block BK3 may be aligned with each other.

As illustrated in FIG. 7F, in an embodiment, the lower support unit BS may provide a flattened support surface on an upper side depending on the alignment operations of the first support unit SU1 and the second support unit SU2. In an embodiment, the flattened support surface may be used as the reference position PS0. In this case, the flatness measurement unit LVU may store the flatness of the reference position PSO as new reference data. In an embodiment, thereafter, even though the positions of the support surfaces are changed depending on the load of an object, the lower support unit BS may be aligned based on data measured by the flatness measurement unit LVU such that support surfaces corresponding to the reference position PSO may be provided.

According to the disclosure, in an embodiment, the flatness of the lower support unit BS may be easily measured using the flatness measurement unit LVU and the additional flatness measurement unit LVS, and based on this, the support surface provided by the lower support unit BS may be stably flattened.

FIGS. 8A and 8B illustrate an embodiment of the alignment step S3 in detail. For ease of description, an embodiment in which the mask unit MKU is disposed as an object is illustrated in FIGS. 8A and 8B. Hereinafter, the alignment step S3 will be described in more detail with reference to FIGS. 8A and 8B.

Referring to FIG. 8A, in an embodiment when the mask unit MKU, which is an object, is disposed on the stage ST, the mask unit MKU may be disposed in an uneven state depending on a load imbalance of the mask unit MKU or a position in which the mask unit MKU is seated. Accordingly, the lower support unit BS supporting the mask unit MKU may be deformed from the state in the reference setting step S1. In this embodiment, the mask unit MKU may be disposed in an inclined state with respect to the first direction DR1 and may be inclined downward to the right, and therefore a predetermined horizontal error GS1 may occur. The horizontal error GS1 may substantially mean a difference from the reference position PS0. In an embodiment the horizontal error GS1 may be a difference between the first support surface S-SB1 and the second support surface S-SB2 and may mean the degree of non-flatness of the support surface provided by the lower support unit BS.

In an embodiment, due to the horizontal error GS1, the link bar LB may be inclined downward to the right, and the state of the link bar LB may be measured by the flatness measurement unit LVU. The flatness measurement unit LVU may provide data corresponding to the reference position PSO set in the reference setting step S1 and may provide data corresponding to the inclined state of the link bar LB in the alignment step S3. In an embodiment, a difference between the data corresponding to the set reference position PSO and the data measured in the alignment step S3 may be data corresponding to the horizontal error GS1. The lower support unit BS may perform an alignment step by operating the first support unit SU1 and the second support unit SU2 based on the data corresponding to the horizontal error GS1.

Specifically, in an embodiment, the first support unit SU1 may move the second support bar SB2 in the direction of an arrow. At this time, flatness may be measured through the flatness measurement unit LVU in real time, and thus more precise alignment may be performed. In addition, each of the blocks BK1, BK2, and BK3 of the second support unit SU2 may be aligned with the reference position PSO by moving again by the changed position with respect to the reference position PSO based on the displacement sensor LS. Accordingly, as illustrated in FIG. 8B, the lower support unit BS may provide support surfaces corresponding to the reference position PS0, and the mask unit MKU may be stably supported on a flattened support surface.

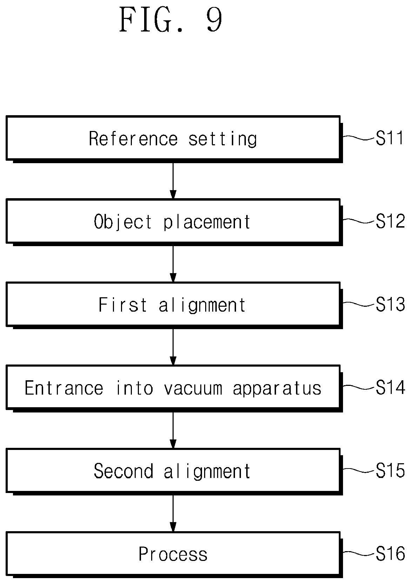

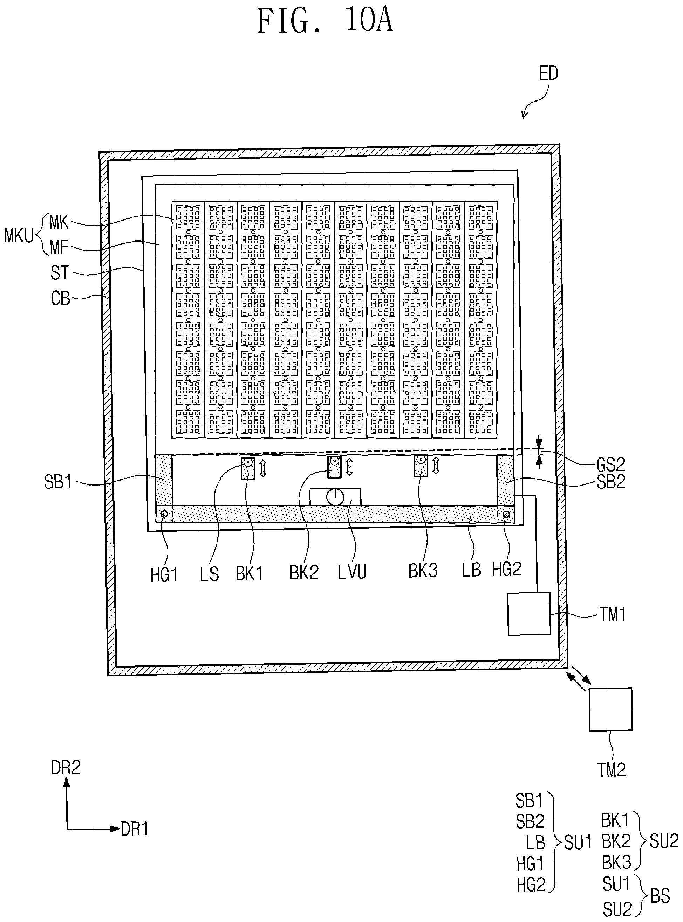

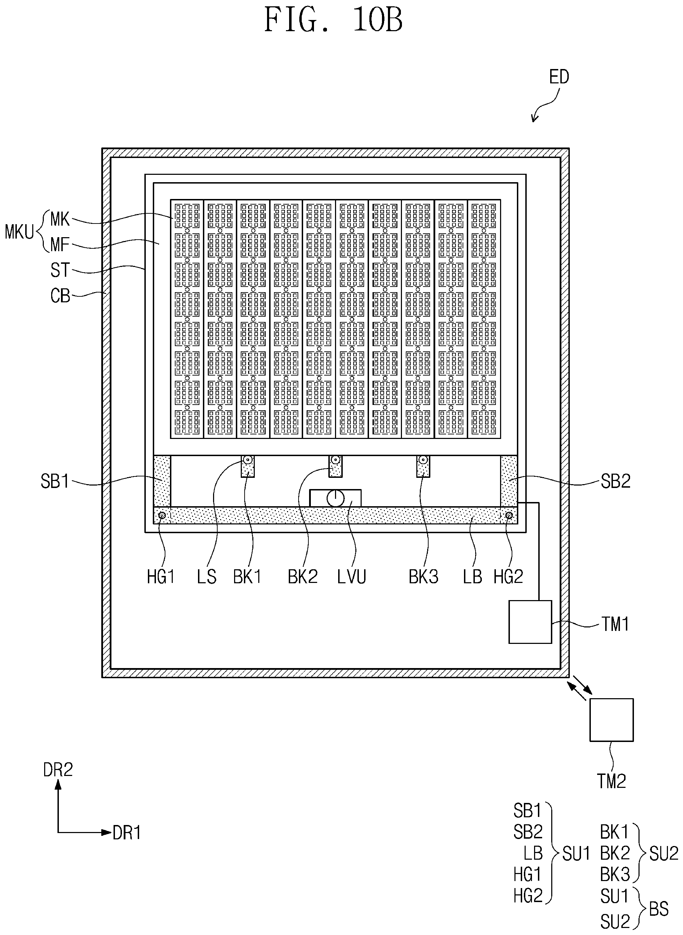

FIG. 9 is a flowchart illustrating a manufacturing process according to an embodiment of the disclosure. FIGS. 10A and 10B are plan views illustrating the manufacturing process according to an embodiment of the disclosure. Hereinafter, the disclosure will be described with reference to FIGS. 9 to 10B. Meanwhile, components identical to the components described with reference to FIGS. 1 to 8B will be assigned with identical reference numerals, and repetitive descriptions will be omitted.

Referring to FIG. 9, the manufacturing process according to an embodiment of the disclosure may include a reference setting step S11, an object placement step S12, a first alignment step S13, a step S14 of entrance into a vacuum apparatus, a second alignment step S15, and a process step S16. The reference setting step S11, the object placement step S12, and the first alignment step S13 may correspond to the steps S1, S2, and S3 described with reference to FIG. 6.
Hereinafter, repetitive descriptions will be omitted.

In an embodiment the step S14 of entrance into the vacuum apparatus may be a step of providing the stage unit STU having an object seated thereon in the inner space of the chamber CB. Accordingly, the space in which the stage unit STU is located may be changed from an atmospheric pressure state to a vacuum state.

In an embodiment, the second alignment step S15 may be an alignment step in the vacuum state. In an embodiment, the process step S16 may be a step performed in the vacuum apparatus and may be, for example, an organic material deposition step. Meanwhile, this is illustrative, and the process step S16 may include various embodiments as long as the process step S16 is performed in the vacuum apparatus, and the process step S16 is not limited to any one embodiment.

FIGS. 10A and 10B illustrate an embodiment of the second alignment step S15 in detail. For ease of description, an embodiment in which the mask unit MKU is disposed as an object is illustrated in FIGS. 10A and 10B. Hereinafter, the second alignment step S15 will be described in more detail with reference to FIGS. 10A and 10B.

In an embodiment, the second alignment step S15 may be performed in the chamber CB. Even though the first alignment step S13 in which the mask unit MKU is aligned in a seated state is performed, the degree of alignment may be changed due to a movement in the process in which the mask MKU moves into the chamber CB. Furthermore, in an embodiment, the degree of alignment may be changed while the inner space of the chamber CB is changed from the atmospheric pressure state to the vacuum state. Accordingly, an embodiment of the second alignment step S15 may be performed in the chamber CB and, in particular, may be performed in the vacuum state. The second alignment step S15 may align the object with the reference position PSO in the vacuum state.

Specifically, referring to FIG. 10A, in an embodiment, a horizontal error GS2 may occur in the chamber CB in the vacuum state. The flatness measurement unit LVU may measure flatness corresponding to the horizontal error GS2. Meanwhile, the lower support unit BS according to an embodiment of the disclosure may further include communication modules TM1 and TM2. In an embodiment, the first communication module TM1 may be physically connected with the lower support unit BS and may be provided in the chamber CB. The second communication module TM2 may be provided outside the chamber CB.

In an embodiment, data generated by the flatness measurement unit LVU may be transferred to the second communication module TM2 through the first communication module TM1. Outside the chamber CB, data for driving the lower support unit BS may be generated based on data received through the second communication module TM2. The generated data may be transferred to the first communication module TM1 through the second communication module TM2, and the driving part of the lower support unit BS may perform an alignment step by driving the first support unit SU1 and the second support unit SU2 based on data received from the first communication module TM1.

Accordingly, as illustrated in FIG. 10B, in an embodiment, the lower support unit BS may provide, to the mask unit MKU, a flattened support surface obtained by improving the horizontal error GS2 through the second alignment step S15. The mask unit MKU may be stably supported by the lower support unit BS in a horizontal state.

According to the disclosure, an embodiment of the manufacturing process may further include the second alignment step S15. Accordingly, in an embodiment, misalignment due to the change from the atmospheric pressure state to the vacuum state may be resolved, and thus the accuracy of the process step S16 may be improved. In addition, in an embodiment, the communication modules TM1 and TM2 may be further included. Accordingly, in an embodiment, the lower support unit BS may be remotely controlled, and thus an alignment step may be easily performed even in the vacuum state.

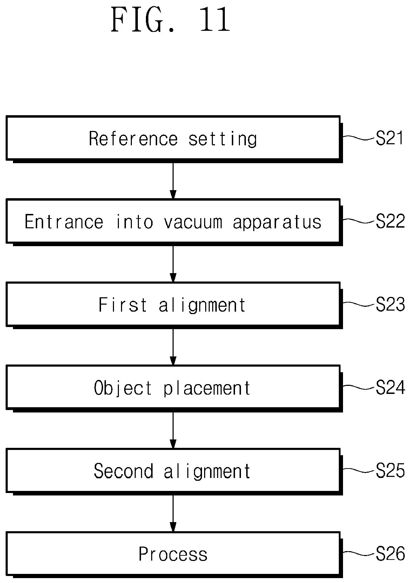

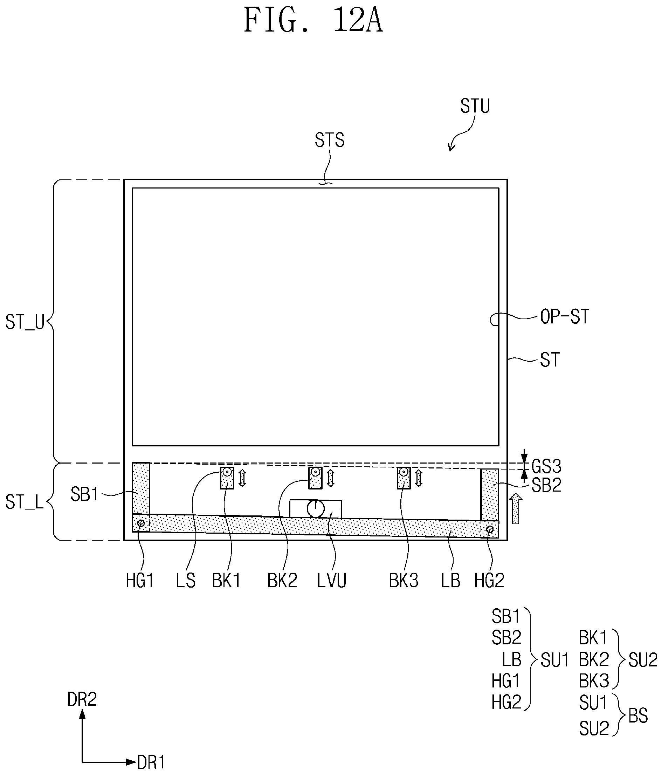

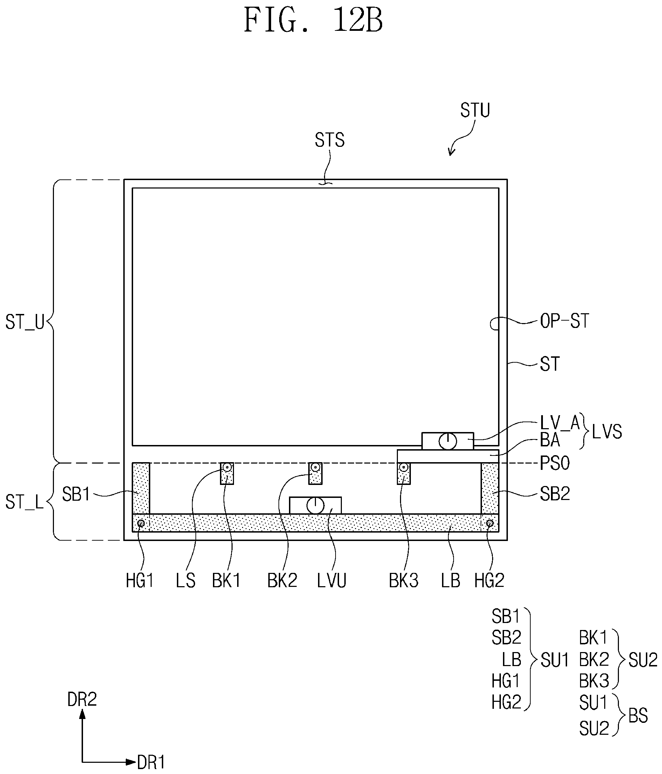

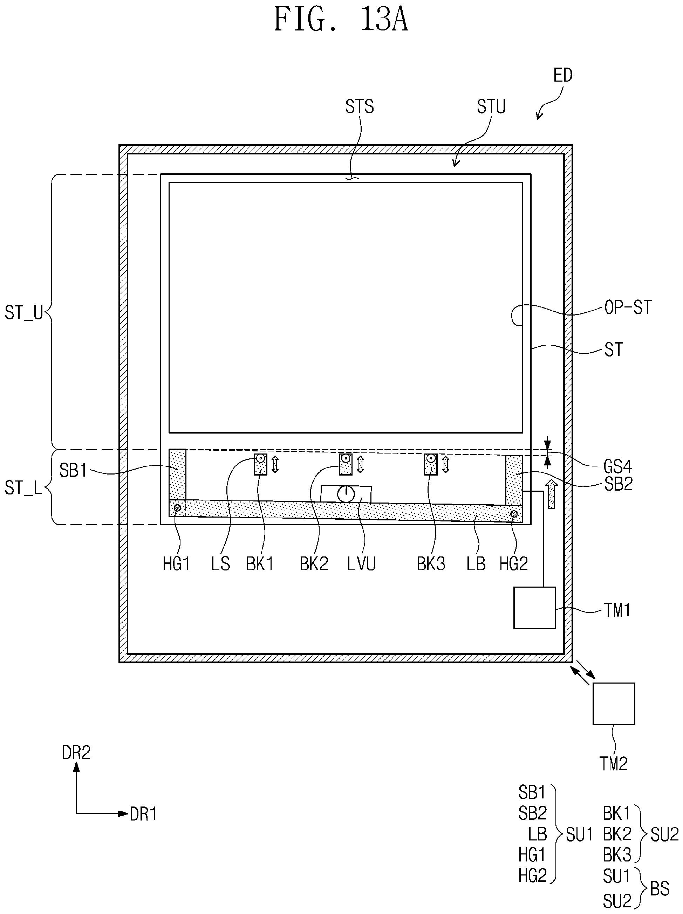

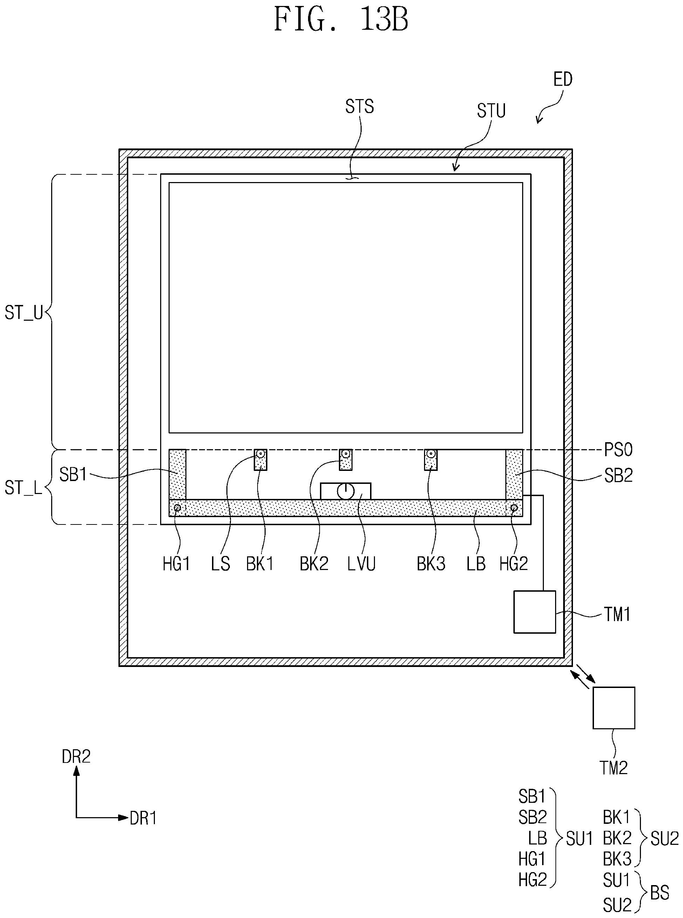

FIG. 11 is a flowchart illustrating a display panel manufacturing process according to an embodiment of the disclosure. FIGS. 12A and 12B are plan views illustrating the display panel manufacturing process according to an embodiment of the disclosure. FIGS. 13A and 13B are plan views illustrating the display panel manufacturing process according to an embodiment of the disclosure. Hereinafter, the present disclosure will be described with reference to FIGS. 11 to 13B. Meanwhile, components identical to the components described with reference to FIGS. 1 to 10B will be assigned with identical reference numerals, and repetitive descriptions may be omitted.

Referring to FIG. 11, the manufacturing process according to an embodiment of the disclosure may include a reference setting step S21, a step S22 of entrance into a vacuum apparatus, a first alignment step S23, an object placement step S24, a second alignment step S25, and a process step S26.

In an embodiment, the reference setting step S21 may be a step of setting the reference position PSO (refer to FIG. 4A) in the stage unit STU before an object is disposed. The reference setting step S21 and the process step S26 may correspond to the reference setting step S1 and the alignment step S3 described with reference to FIG. 6. Hereinafter, repetitive descriptions will be omitted.

In an embodiment, the step S22 of entrance into the vacuum apparatus may be a step of providing the stage unit STU in the inner space of the chamber CB. In this case, the stage unit STU may be in a state in which the object is not seated thereon.

Thereafter, in an embodiment, the first alignment step S23, the object placement step S24, and the second alignment step S25 may be sequentially performed. In this embodiment, the object may be provided in the chamber CB and may be seated on the stage unit STU in the chamber CB.

In an embodiment, the first alignment step S23 may be an alignment step in the state in which the object is not seated. That is, the first alignment step S23 may be a step of aligning a horizontal error caused by a change from an atmospheric pressure state to a vacuum state or a horizontal error occurring as the object is moved while being loaded into the chamber CB.

In an embodiment, the second alignment step S25 may be an alignment step in the state in which the object is seated. That is, the second alignment step S25 may be a step of aligning a horizontal error due to load concentration that occurs as the object is seated.

FIGS. 12A and 12B illustrate an embodiment of the reference setting step S21 in detail, and FIGS. 13A and 13B illustrate an embodiment of the first alignment step S23 in detail. Referring to FIGS. 12A and 12B, in an embodiment, the stage unit STU may be aligned in the atmospheric pressure state. As described above, the reference setting step S21 may be a step of setting horizontality before the object is seated on the stage ST and may set a support surface provided by the lower support unit BS to be flat in a state in which the load of the object does not exist.

In this embodiment, the stage unit STU may be in a state in which a horizontal error GS3 occurs. The horizontal error GS3 may occur in the atmospheric pressure state, or may occur in the state in which the load of the object is not applied. Since this alignment step is performed in the atmospheric pressure state, the flatness of each of the blocks BK1, BK2, and BK3 may be measured through the additional flatness measurement unit LVS. Accordingly, in an embodiment, the flatness of the support surface provided by the lower support unit BS may be more precisely controlled. In an embodiment, FIG. 12B may be a state set as a reference position and may be a state in which the lower support unit BS provides a flattened support surface.

In an embodiment and referring to FIGS. 13A and 13B, the stage unit STU may be aligned in the vacuum state. As described above, in an embodiment, the first alignment step S23 may be a step of setting horizontality before the object is seated on the stage ST, and a horizontal error GS4 existing at this time may occur during a change to the vacuum state in the state in which the load of the object is not applied, or may occur while the object moves into the chamber CB.

In an embodiment, data corresponding to the horizontal error GS4 may be measured by the flatness measurement unit LVU, and the corresponding data may be transferred to the outside of the chamber CB through the first communication module TM1 and the second communication module TM2. Thereafter, in an embodiment, driving data corresponding thereto may be transferred to the lower support unit BS through the first communication module TM1 and the second communication module TM2, and movements of the first support unit SU1 and the second support unit SU2 may be easily controlled even in the vacuum state. According to the present disclosure, in an embodiment, an alignment step for flattening the support surface provided by the lower support unit BS may be easily performed regardless of the atmospheric pressure state or the vacuum state. Accordingly, in an embodiment, the process may be simplified, the alignment error may be reduced, and the accuracy may be improved. In addition, even though the stage unit STU is deformed as the load of the object depending on the gravity is concentrated, in an embodiment, the position of the lower support unit BS may be reset to the reference position PS0, and thus the accuracy of the process may be improved.

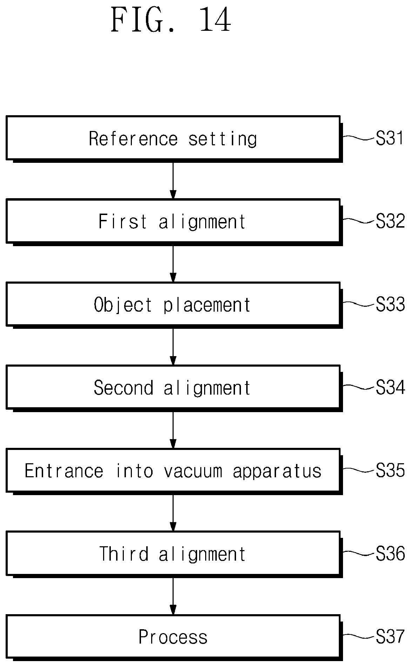

FIG. 14 is a flowchart illustrating a display panel manufacturing method according to an embodiment of the disclosure.

Referring to FIG. 14, the manufacturing method according to an embodiment of the disclosure may include a reference setting step S31, a first alignment step S32, an object placement step S33, a second alignment step S34, a step S35 of entrance into a vacuum apparatus, a third alignment step S36, and a process step S37. In an embodiment, the manufacturing method illustrated in FIG. 14 may further include the first alignment step S32 between the references setting step S31 and the object placement step S33, compared to the manufacturing method illustrated in FIG. 9.

In an embodiment, the first alignment step S32 may correct a horizontal error that is likely to occur between the reference setting step S31 and the object placement step S33. When the stage unit STU moves or a surrounding environment is changed between the reference setting step S31 and the object placement step S33, the accuracy of an alignment step may be improved by additionally performing the alignment step 32. In addition, in an embodiment, the degree of a horizontal error that is likely to occur in the second alignment step S34 may be controlled so as not to be excessively large.

According to the embodiments of the disclosure, an alignment step may be performed in various steps. The alignment step according to embodiments of the disclosure may accurately and precisely control the flatness of the object by using the lower support unit BS and the flatness measurement unit LVU, and the alignment step of the object may be easily performed despite various environmental changes.

According to the present disclosure, the flattened support surface may be easily provided for the vertically seated object. Accordingly, the deposition accuracy may be improved in the process of manufacturing the display panel. In addition, concentration of a load on the object may be alleviated, and the support surface may be easily flattened even in a vacuum state.

While the disclosure has been described with reference to embodiments thereof, it will be apparent to those of ordinary skill in the art that various changes and modifications may be made thereto without departing from the scope of the disclosure as set forth in the following claims.

The invention should not be construed as being limited to the embodiments set forth herein. Rather, these embodiments are provided so that this disclosure will be thorough and complete and will fully convey the concept of the invention to those skilled in the art. The embodiments and/or parts of the embodiments may be combined in whole or in part without departing from the scope of the disclosure. In addition, many modifications may be made to adapt a particular situation or material to the teachings of the disclosure without departing from the scope thereof.

## Claims

1. A stage unit comprising:
a stage including a seating surface, the stage having an opening formed through the seating surface;
a first support unit disposed below the opening and coupled to the stage;
a second support unit disposed below the opening and coupled to the stage, wherein the second support unit is spaced apart from the first support unit on a plane; and
a flatness measurement unit supported by the first support unit,
wherein each of the first support unit and the second support unit includes a support surface which crosses the seating surface, and
wherein the support surface of the first support unit and the support surface of the second support unit are movable in a direction toward and away from the opening.

2. The stage unit of claim 1, wherein the seating surface is in a direction substantially parallel to a direction of gravity.

3. The stage unit of claim 1 or claim 2, wherein a movement direction of the support surface of the first support unit and the support surface of the second support unit is in a direction substantially parallel to a direction of gravity.

4. The stage unit of any one of claims 1 to 3, wherein the first support unit includes:
a first support bar including a first support surface;
a second support bar including a second support surface and spaced apart from the first support bar in a first direction; and
a link bar connecting the first support bar and the second support bar, and
wherein the flatness measurement unit makes contact with the link bar.

5. The stage unit of claim 4, further comprising:
a first hinge connected through the first support bar and one side of the link bar; and
a second hinge connected through the second support bar and an opposite side of the link bar,
wherein when the support surface of the first support unit and the support surface of the second support unit move, a position of the first hinge is fixed, and a position of the second hinge is changed.

6. The stage unit of claim 4 or claim 5, wherein the first support surface and the second support surface define a same plane or a different plane.

7. The stage unit of any one of claims 4 to 6, wherein the second support unit includes a plurality of blocks disposed between the first support bar and the second support bar, and
wherein each of the blocks includes a third support surface which defines the support surface.

8. The stage unit of claim 7, wherein the blocks are independently movable in a second direction crossing the first direction, and
wherein the third support surface defines a same plane or a different plane.

9. The stage unit of claim 7 or claim 8, further comprising:
an additional flatness measurement unit configured to control flatness of the third support surface, the first support surface and the second support surface.

10. The stage unit of any one of claims 1 to 9, further comprising:
a wireless communication module connected with the first support unit and the second support unit.

11. A deposition apparatus comprising:
a chamber defining an inner space;
a deposition member accommodated in the inner space and including a deposition material;
a stage including a seating surface parallel to a plane defined by a first direction and a second direction, the stage having an opening formed through a portion of the seating surface;
a mask unit disposed on the seating surface to overlap the opening, the mask unit having a plurality of openings defined therein;
a lower support unit disposed below the opening and coupled to the stage, the lower support unit being configured to support the mask unit; and
a substrate including a front surface which faces the seating surface, the substrate being spaced apart from the deposition member in a third direction crossing the first direction and the second direction with the mask unit and the stage therebetween,
wherein the lower support unit includes:
a support unit including a support surface in contact with one side surface of the mask unit and extending in the first direction; and
a flatness measurement unit disposed on the support unit, and
wherein the support surface is connected with the flatness measurement unit and movable in the second direction.

12. The deposition apparatus of claim 11, wherein:
(i) the inner space is in a vacuum state; and/or
(ii) the mask unit includes:
a mask frame defining an opening which overlaps the opening of the stage; and
a plurality of masks, each of which includes the plurality of openings defined therein, the plurality of masks being disposed to overlap the opening of the mask frame; and/or
(iii) the deposition apparatus further comprises:
a communication module connected to the lower support unit,
wherein the communication module is in communication with the outside of the chamber.

13. The deposition apparatus of claim 11 or claim 12, wherein the support surface includes:
a first support surface supporting one end of the one side surface of the mask unit;
a second support surface supporting an opposite end of the one side surface of the mask unit; and
a plurality of third support surfaces disposed between the first support surface and the second support surface and arranged in the first direction to be spaced apart from each other,
wherein the first support surface, the second support surface and the third support surfaces are independently controlled, optionally wherein the flatness measurement unit is configured to measure flatness between the first support surface and the second support surface.

14. A method for manufacturing a display panel, the method comprising:
providing a stage unit including a stage having a seating surface and a lower support unit having a support surface;
setting a reference position at which the support surface is flattened;
providing an object on the seating surface; and
aligning the lower support unit such that a support surface supports the object corresponding to the reference position, wherein
the support surface crosses the seating surface, and
a flatness measurement unit is used to set the reference position.

15. The method of claim 14, wherein:
(i) the support surface crosses a direction of gravity; and/or
(ii) the support surface includes a plurality of support surfaces, and
wherein positions of the support surfaces are independently movable in a direction of gravity when the lower support unit is aligned; and/or
(iii) at least one of,
the setting of the reference position is performed in an atmospheric pressure state, and
the aligning of the lower support unit is performed in a vacuum state.
